# EUROPEAN PATENT APPLICATION

(11) **EP 2 521 157 A1**
(43) Date of publication of application: **07.11.2012**
(21) Application number: 11164930.7
(22) Date of filing: 05.05.2011
(51) Int. Cl.: H01J 37/244, H01J 37/26

(54) **Segmented charged particle detector using scintillator material**

(71) Applicant: FEI COMPANY, Hillsboro, Oregon 97124-5793 (US)
(72) Inventor: Hlavenka, Petr, 61200, BRNO (CZ); Uncovsky, Marek, 61300, BRNO (CZ)
(74) Representative: Bakker, Hendrik

(57) **Abstract**

The invention relates to a segmented scintillator detector for detecting electrons in an electron microscope. The invention proposes to use 2 (or more) scintillator materials (204A,204B), each material emitting at a different wave length. The light from two segments can then be guided to a beam splitter (for example a dichroic mirror) by a common light guide (106), while after the beam splitter (206) the light of each colour/scintillator is detected separately by a photon detector (208A,208B). Especially YAP and YAG scintillators are well-suited for this invention, but also powder scintillator such as P47.

## Description

The invention relates to a segmented charged particle detector for detecting charged particles in a charged particle microscope, the detector comprising a multitude of scintillator segments and a multitude of photosensitive areas, each segment coupled to an associated photosensitive area via one or more light guides.

Such a detector is known from US patent No. 7,928,383.

The known patent discloses a detector consisting of a plurality of independent light guide modules assembled together to form a segmented detector. One side of each light guide (the side facing a specimen from which charged particles emerge) is coated with or bonded to scintillator material. The other side of each light guide is connected to a photosensitive device, such as a photomultiplier tube.
The segmented detector is used, for example, in an apparatus equipped with a Scanning Electron Microscope (SEM) column and/or a Focused Ion Beam (FIB) column. The detector is used for, for example, detecting secondary electrons (SEs) or backscattered electrons (BSEs). As known to the person skilled in the art angular information of SEs and BSEs is translated to positional information on a detector. Angular information gives information on, for example, topography of the sample.
The detector may also be used, in conjunction with for example magnetic or electrostatic fields, to distinguish between Secondary Electrons (SEs), typically emerging from the sample with an energy of less than 50 eV, and BSEs, typically leaving the sample with an energy of 50 eV or more. The magnetic or electrostatic fields manipulate the SEs and BSEs such, that the SEs hit the detector at another position than the BSEs.

It is noted that typically the scintillator is coated with a very thin (10-100 nm) layer of an electrically conductive material, such as a metal oxide (a well-known example is indium-tin oxide, ITO) or aluminium, to avoid charging of the scintillator. This conductive layer can also be biased to a voltage of several keV with respect to the sample to enlarge the number of photons produced per incoming electron.

It is further noted that a scintillator detector is capable of detecting electrons, but also of detecting ions, clusters of atoms (charged and not charged) and molecules (charged and non-charged), as well as X-rays.

Often the light guides are formed as fibers or cylinders passing through the wall of the vacuum enclosure of such an apparatus, so that the photo-sensitive devices/areas (light detectors), for example a number of photo-multiplier tubes (PMTs), can be placed outside the vacuum of the apparatus. In other cases, as also described in the known patent, the detector is at least partly positioned within the objective lens of such an instrument, where there is very little space. It is clear that a large number of light guides results in a complex and thus expensive detector and also expensive and complex requirements for integrating the detector in a charged particle microscope.

It is noted that segments in this context should be construed widely, and include zonal structures, in which a series of rings surround each other, wedges, squares adjacent to each other, and other lay-outs

A disadvantage of the known detector is the large number of light guides used.

The invention intends to provide a solution to this.

To that end the detector according to the invention is **characterized in that**
- the multitude of segments are each formed by one of at least two types of scintillator materials,
- the at least two types of scintillator materials emitting light of a different colour,
- at least one light guide comprises a part in which photons of at least two segments, each segment emitting photons with a different colour, are combined, the photons guided to a part where the colours are split apart, and each colour then coupled to a photosensitive areas.
as a result of which the number of light guides is less than the number of segments.

The invention is based on the insight that, when using -for example- two different scintillator materials emitting light with different colours, part of the optical path of two segments can be combined. Combining the light from the two segments involves simply coupling two segments to a light guide (instead of coupling one segment to a light guide). Splitting the light can be done with, for example, a dichroic beam splitter (comprising a dichroic mirror). From the beam splitter two beams will exit, one for each colour, each of the colours to be detected by associated photosensitive areas. The number of light guides is thereby halved, although the part near the photosensitive areas is slightly more complex. However, this can be realized in an area where space is not as important as inside a lens or in a vacuum feed-through.

It is noted that a detector using two types of scintillators is described in US patent No. 6,392,248. This patent discloses a radiography system for monitoring X-rays, in which the screen comprises a mixture of powders emitting light in different colours, and each of these powders/colours having a different light efficiency when exposed to a similar dose of X-rays, and that said efficiency varies with the intensity. As a result the resultant colour of the screen is dependent on the intensity of the X-rays. The disclosed multi-colour detector differs from the detector according to the invention in that it is not a segmented detector, and the colours do not give information of the position.

It is further noted that the use of multiple powders in one segment does not make sense in a detector according to the invention, as one impinging charged particle typically stimulates only one powder particle. As a result the colour does not give information of the intensity, nor of the energy of the impinging particles.
It is also noted that the choice of scintillator material is not governed by the emission colours only: as known to the person skilled in the art the decay time of detectors for e.g. a SEM or a FIB must be short, typically less than 100 ns. Also the efficiency (number of photons per impinging particle) is important. Luckily two scintillators with high performance, but different colours, are known and used in, for example, SEMs: YAP:Ce (cerium doped yttrium aluminium perovskite, YAlO₃, showing a peak emission at a wavelength of 378 nm), and YAG:Ce (cerium doped yttrium aluminium garnet, Y₃Al₅O₁₂, showing a peak emission at a wavelength of 560 nm). Also a powdered scintillator, P47, yttrium silicate activated with cerium, YSi₂O₇:Ce, showing a peak emission at a wavelength of 400 nm, is widely used.
Preferably at least one segment uses YAP:Ce as a scintillator and at least one segment uses YAG:Ce as a scintillator.

Using two different colours the number of light guides can in principle be halved. Using three different colours (and using two dichroic splitters) the number of light guides can even be reduced by a factor of three.

The photosensitive areas can be areas on photosensitive devices from the group of devices comprising a photodiodes, an avalanche photodiodes, a Geiger-mode photodiodes, a multi-pixel-photon counter (also known as a Si-PMT), a photomultiplier tubes, each device associated with one sector. As an alternative one device capable of positional detection, such as a CCD or CMOS chip, may be associated with several sectors.

As known to the skilled person a scintillator emits photons only when the particles are sufficiently energetic. YAP and YAG scintillators are often used to detect electrons with an energy of between 5 keV and 15 keV, typically approximately 10 keV. In order to detect secondary electrons, typically emerging from the sample with an energy of 50 eV or less, the electrons are accelerated towards the scintillator. Therefore, in a preferred embodiment, the scintillator is covered with a thin, electrically conducting coating of, for example, aluminium or indium tin oxide and the detector is equipped with a voltage generator for biasing the coating with respect to ground. A further advantage of an aluminium coating is that this is also an optically reflective coating, guiding photons to the light guide.

It is noted that the sample need not be at ground potential, but may be biased with, for example, a negative voltage of several keV with respect to ground. In that case the biasing of the coating need not be as large (for a comparable light efficiency) as when the sample is not biased.

In another embodiment the detector is used in an apparatus showing a sample position, said sample position positioned between the column and the charged particle detector.

The detector is here used as a transmitted electron detector, to detect electrons that are transmitted through a thin sample.

The invention is now elucidated with figures, where corresponding numerals indicate corresponding features. To that end:
figure 1A and 1B schematically show a prior art, non-segmented, scintillator detector.
figure 2A and 2B schematically show a segmented scintillator detector according to the invention.
figure 3 schematically shows a scintillator disk for use in a detector according to the invention.

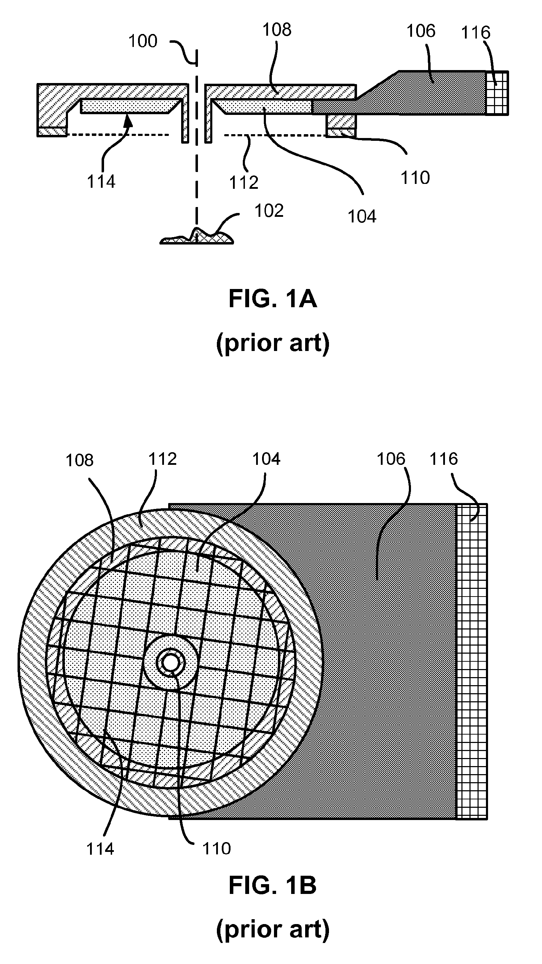

Figure 1A and 1B schematically show a prior art non-segmented scintillator. Such a detector is described in "Detection of backscattered electrons in low voltage scanning electron microscope", P. Wandrol, Doctoral Degree Programme (2), available on the internet at http://www.feec.vutbr.cz/EEICT/2004/sbornik/03-Doktorske projekty/06-Mikroelektronika a technologie/32-wanis.pdf.

Figure 1A shows a sectional drawing of the detector. It shows an axis 100 along which, in working, a primary beam of charged particles travels from a charged particle source (not shown) to a sample 102 (sample not part of the detector). Such charged particles include electrons, positively or negatively charged ions, clusters, and molecules. Round the axis a disk of scintillator material 104 is placed, that is coupled to a light guide 106. The scintillator disk is placed in a grounded, metallic, body 108, which also shows a tubular part 110. On the body 108 a holder 112 holding a grid 114 is placed. The light guide 106 guides light from the scintillator disk 104 to a photon detector 116.

When electrons or ions from the primary beam hit the sample 102, radiation in the form of, for example, secondary electrons (SEs) and backscattered electrons (BSEs) emerges from the sample. SEs typically emerge from the sample with an energy of 50 eV or less, BSEs typically with an energy of 50 eV or more (up to the energy of the impinging particles).

It is noted that also other types of radiation, such as X-rays and visible light emerge from the sample.

In a first mode of use of the detector, in which the detector detects solely BSEs and no SEs, the grid 114 is negatively biased with respect to the sample to a voltage of, for example, -100 V, thus acting as a retarding grid. SEs are not transmitted through the grid to the scintillator 104 due to the retarding field. The scintillator shows a thin electrically conductive coating 118, that allows this side of the scintillator to float at a positive voltage of several kV with respect to the sample, typically to a voltage of 5 kV. The electrons transmitted through the grid are thus further accelerated and hit the scintillator with a minimum energy of 5 keV, as a result of which scintillation occurs.

In a second mode of use the grid is positively biased, and both BSEs and SEs are transmitted through the grid to the scintillator, and thus both types of electrons are detected.

It is noted that the tubular part 110 is intended to shield the primary beam from the voltages on the scintillator that may otherwise defocus the primary beam, or even prevent the primary beam of arriving at the sample.

The light guide 106 guides the photons produced in the scintillator 104 to the photon detector 116. The light guide may, for example, be a polymethylmetacrylate (PMMA) body, or quartz, glass.

Often the light guide also serves as part of a vacuum feed-through, in which case somewhere between the scintillator and the photon detector it shows a form with rounded edges to accommodate a seal using an O-ring.

The photon detector can be a photodiode, an avalanche photodiode (APD), a Geiger-mode APD, a photomultiplier (PMT), a multi-pixel photon counter (also known as a Si-PMT), or arrays thereof, including CMOS and CCD chips.

The scintillator is often a YAP:Ce or a YAG:Ce monocrystal, although also disks made of for example glass and covered with a scintillating powder (e.g. P47) are known to be used. For some applications, for example applications requiring very short decay times, also other scintillators, such as plastic scintillators are used.

Figure 1B schematically shows the scintillator detector as seen from the sample.

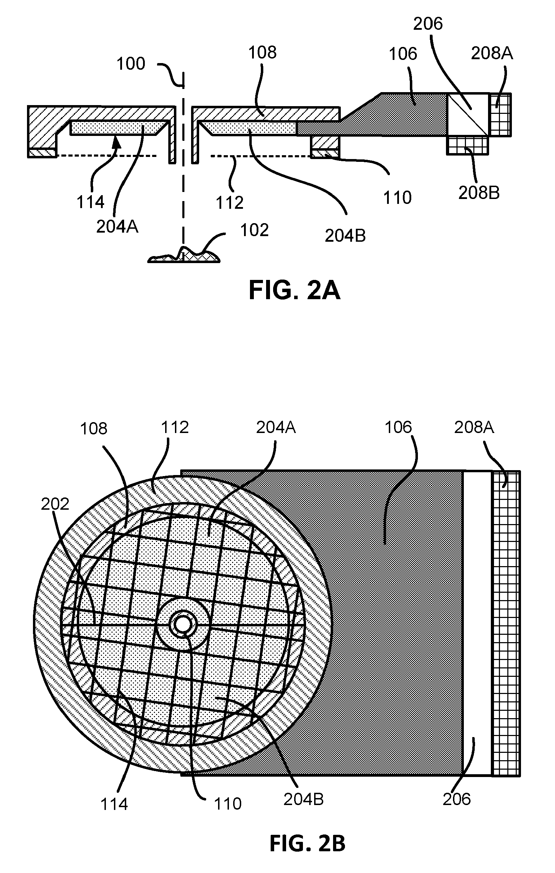

Figure 2A and figure 2B schematically show the scintillator detector according to the invention.

Figure 2A and figure 2B can be thought to be derived from figure 1A and figure 1B, respectively. The scintillator disk is segmented in two halves, 204A and 204B, along line 202. The two halves are formed from different scintillator materials, emitting light with a different wave length, for example YAP:Ce (showing a peak emission at a wavelength of 378 nm) and YAG:Ce (showing a peak emission at a wavelength of 560 nm). The light from the two different scintillators is guided through one light guide 104, and is split into two different light paths by a dichroic beam splitter 206. The two different light beams coming from the beam splitter are detected by two different photon detectors, 208A and 208B, respectively.

Although the invention is explained here with a two-segment scintillator, the person skilled in the art, combining the teaching of earlier mentioned US patent No. 9,928,383 and the invention described here, can construct detectors with more than two segments, including 4-quadrant detectors. Also detectors with two (or more) annular zones can be constructed, or any combination hereof.

Figure 3 schematically shows a scintillator disk for use in a detector according to the invention.

Although YAP and YAG emit photons of different energy (wavelength), the crystals are transparent to each other's photons. Therefore a YAP crystal/scintillator can be part of the light guide of a YAG scintillator and vice versa.
Therefore, in an embodiment, a scintillator disk 301 made of one scintillator material is partly covered with one or more thin layers of another scintillator 302. The thin layer can be formed from a single crystal (e.g. YAP or YAG), but may also be a powder scintillator (P47), or a plastic scintillator, directly or indirectly attached to the underlying crystal or otherwise (for example via a bonding medium). Herewith the detector of figure 1 can easily be adopted by exchanging disk 104 by the disk of figure 3 (and adding the beam splitter and extra photon detector).

It is noted that the electrons impinging on scintillator 302 will not penetrate to stimulate scintillator 301, as the penetration depth of electrons with an energy of several keV or even tens of keV in solids is limited to one or a few µm.

Scanning Electron Microscope (SEM) columns and Focused Ion Beam (FIB) columns, as well as instruments equipped with one or more of these columns are known *per se* to the skilled artisan.

It is noted that the detector according to the invention can be placed between a particle-optical column, such as a scanning electron microscope column or a FIB column, and the sample, or inside such a column (partly or in whole). Detectors inside a column can in turn be positioned inside the lens closest to the sample to be inspected (the so-named objective lens), or further removed from the sample. Examples of in-column detectors are, for example, shown in US patent No. 4,831,266. Depending on their configuration the scintillator disks must show a central hole for passing the beam of primary charged particles, or the central hole can be eliminated. The latter is obviously the case when the sample is placed between the scintillator and the column (a so-called transmission detector).

It is further noted that the different scintillators may show different efficiencies, either due to their different behavior or due to other geometry with respect to the common light guide. This can be compensated for by using a different amplification in or after the photon detector.

## Claims

1. A segmented charged particle detector for detecting charged particles in a charged particle microscope, the detector comprising a multitude of scintillator segments (204A, 204B) and a multitude of photosensitive areas (208A, 208B), each segment coupled to an associated photosensitive area via one or more light guides (106), **characterized in that**
• the multitude of segments are each formed by one of at least two types of scintillator material used,
• the at least two types of scintillator material emitting light of a different colour,
• at least one light guide comprises a part in which photons of at least two segments, each segment emitting photons with a different colour, are combined, the photons guided to a part (206) where the colours are split apart, and each colour then coupled to a photosensitive areas.
as a result of which the number of light guides is less than the number of segments.

2. The detector of claim 1 in which the detector comprises two types of scintillator material and has an even number of segments and the number of light guides is half the number of segments.

3. The detector of any of claims 1 or 2 in which the part (206) where the colours are split apart is a dichroic mirror.

4. The detector of any of the preceding claims in which the multitude of photosensitive areas (208A, 208B) are photosensitive areas on devices from the group of a photo-diode, an avalanche photodiode, a Geiger mode avalanche photodiode, a multi-pixel photon detector, a CMOS device, a CCD device, or a photomultiplier tube.

5. The detector of claim 4 in which at least two photosensitive areas are formed on one photosensitive device capable of giving place dependent information.

6. The detector of claim 5 in which the photosensitive device is a CMOS device or a CCD device.

7. The detector of claim 4 in which the multitude of photosensitive areas are formed on separate photosensitive devices

8. The detector of any of the preceding claims in which the detector is equipped with a voltage generator for biasing the scintillator with respect to ground.

9. The detector of any of the preceding claims in which the at least two types of scintillator materials are YAP:Ce and YAG:Ce.

10. The detector of any of the preceding claims in which one scintillator material emitting photons of a fist colour acts as a light guide for the other scintillator, emitting photons of the other colour.

11. Particle-optical apparatus equipped with a detector according to any of the preceding claims.

12. Particle-optical apparatus according to claim 11 comprising a scanning electron microscope column and/or a focused ion beam column.

13. Particle-optical apparatus according to claim 11 or claim 12 in which the scintillator detector is equipped to detect back-scattered electrons.

14. Particle-optical apparatus according to any of claims 11-13 in which the apparatus has a sample position, said sample position positioned between the column and the charged particle detector.
